# EUROPEAN PATENT SPECIFICATION

(11) **EP 1 083 633 B1**
(45) Date of publication and mention of the grant of the patent: **09.07.2003**
(21) Application number: 00307401.0
(22) Date of filing: 29.08.2000
(51) Int. Cl.: H01R 12/38

(54) **Connecting terminal of a flat circuit body**
Anschlussklemme eines Flachschaltungskörpers
Borne de raccordement d'un corps de circuit plat

(30) Priority: 07.09.1999 JP 25329199
(43) Date of publication of application: 14.03.2001
(73) Proprietor: Yazaki Corporation, Minato-ku, Tokyo (JP)
(72) Inventor: Kuwayama, Yasumichi, c/o Yazaki Parts Co. Ltd., Haibara-gun, Shizuoka (JP); Asakura, Nobuyuki, c/o Yazaki Parts Co. Ltd., Haibara-gun, Shizuoka (JP)
(74) Representative: Haley, Stephen

(56) References cited:
- EP-A- 0 286 422
- US-A- 4 012 101
- US-A- 5 137 468
- US-A- 5 314 351

## Description

The present invention relates to a connecting terminal of a flat circuit body, and more particularly to the connecting terminal of the flat circuit body which can be electrically connected reliably to a conductive part of the flat circuit body such as an FPC (flexible printed circuit), an FFC (flexible flat cable), or a ribbon cable, for example.

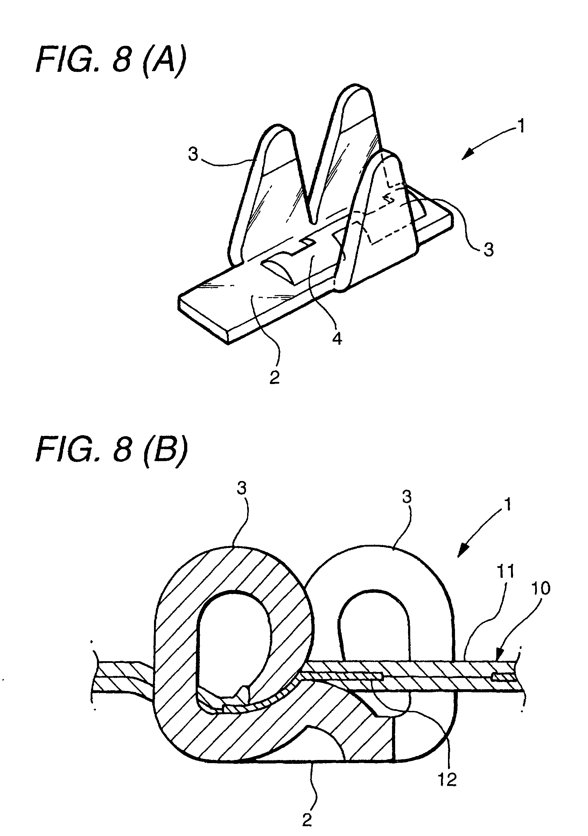

Fig. 8 shows a conventional connecting terminal as described in Japanese Publication No. JP-A-4-8372U of unexamined Utility Model Application. This connecting terminal 1 includes a strip portion 2, claw portions 3 projected from the strip portion 2 in a direction of its thickness, and an arcuate contact part 4 projectingly provided on the strip portion 2 as shown in Fig. 8(A).

When this connecting terminal 1 is put to use, after the connecting terminal 1 is positioned below a conductive part 12 of a flat circuit body 10, as shown in Fig. 8(b), and the claw portions 3 are passed through an insulating part 11, the claw portions 3 are folded back toward the strip portion 2 thereby to hold the conductive part 12 between the arcuate contact part 4 and the claw portions 3 on the strip portion 2 enabling the connecting terminal 1 and the flat circuit body 10 to be electrically connected.

By the way, because the above described connecting terminal 1 is so constructed as to hold the conductive part 12 between the strip portion 2 and the claw portions 3, there has been a fear that the conductive part 12 may be damaged in case where a gap between the strip portion 2 and the claw portions 3 is narrower than a prescribed value when the claw portions 3 are folded back. Therefore, it has been necessary in the conventional connecting terminal 1 to control a height of the claw portions 3 with respect to the strip portion 2 with high precision, which has incurred a high manufacturing cost.

Further, the arcuate contact part 4 which is projectingly formed on the strip portion 2 in the above described connecting terminal 1 is not elastic, and therefore, an effect of relieving a force when the claw portions 3 are folded back cannot be expected.

The invention has been made in view of the above described problems, and its object is to provide a connecting terminal of a flat circuit body which will not damage the conductive part of the flat circuit body, can be electrically connected to the conductive part of the flat circuit body reliably, and can be manufactured at a lower cost.

US-A-5137468 which represents the closest prior art discloses a connecting terminal adapted to be electrically connected to a conductive part of a flat circuit body.

In order to attain the above described object, there is provided a connecting terminal adapted to be electrically connected to a conductive part of a flat circuit body, the connecting terminal comprising:
a strip portion;
at least one claw portion projected from the strip portion in a direction of the thickness of the strip portion; characterised by
at least one projected part being elastically projected from the strip portion in said direction.

The strip portion and the claw portions may be integrally formed, or alternatively, may be formed as separate bodies and then assembled into an integral body by welding or with a conductive adhesive, provided that they are made of appropriate metal having conductivity.

The claw portions may be in any shape in their tip ends and in any member, provided that the conductive part can be clamped between the claw and the strip portion. In case where a plurality of claw portions or a single claw are arranged on both sides of the strip portion respectively, the claw portions on the both sides may be symmetrically arranged or alternatively, in a staggered relation in a longitudinal direction of the strip portion.

As for the projected part, it is essential only that the projected part can be elastically contacted with respect to the tip end of the claw which is folded back, and the projected part of such a structure as cut out from a portion of the strip portion in a form of an arcuate plate, for example, can be employed. The projected part may be formed as a separate body from the strip portion, and may be a leaf spring, for example, manufactured as a separate body to be assembled onto the strip portion as the projected part supported between the claw portions. In case where the portion of the strip portion is cut out to form the projected part, the projected part need not be connected to the strip portion at its both ends, but may be connected only at one end. Further, the projected part itself need not be necessarily conductive, and an elastic material such as rubber can be attached to the strip portion to form the projected part having elasticity.

In the connecting terminal of the flat circuit body constructed in this manner, when the claw portions are passed through the insulating part of the flat circuit body and folded back, the conductive part will be held between the elastic projected part provided on the strip portion and the claw portions. Accordingly, the connecting terminal will be of course electrically connected to the conductive part of the flat circuit body as in the conventional case, and such a fear that the claw portions may be press-contacted onto the conductive part with a force above the prescribed value will be eliminated, because the projected part is elastically deformed to relieve the force from the claw portions when the tip ends of the claw portions press the projected part through the conductive part with a strong force. In other words, manufacturing cost for the connecting terminal of the flat circuit body of this structure can be decreased as compared with the conventional connecting terminal, since there is no fear of damaging the conductive part of the flat circuit body, even though the claw portions are not formed with high precision so that the projected length may be within the prescribed value.

The invention is further characterized in that the projected part is formed by partially cutting out the strip portion.

Although the projected part may be manufactured as a separate body from the strip portion and then assembled onto the strip portion as described before, the projected part is formed by partially cutting out the strip portion in the connecting terminal. Therefore, as compared with the case wherein the projected part is made of separate material and then assembled, number of the components can be reduced, thus restraining an increase of the manufacturing cost.

The invention is further characterized in that the projected part is projected from the strip portion in an arcuate shape.

In the connecting terminal of the flat circuit body constructed in this manner, favorable elasticity can be obtained because the projected part is projected from the strip portion in an arcuate shape.

The invention is further characterized in that the projected part is provided with unevenness portion on its contact face with respect to the conductive part.

In the connecting terminal of the flat circuit body constructed in this manner, because the projected part is provided with unevenness portion on its contact face with respect to the conductive part, an area to be in contact with the conductive part can be enlarged as compared with a case where the unevenness portion are not provided. Therefore, when the projected part is made of metal, favorable conductivity can be obtained. Further, because a surface of the conductive part is press-contacted to the unevenness portion , such a fear that positional displacements of the flat circuit body with respect to the connecting terminal may occur in a longitudinal direction of the conductive part will be decreased, and a favorable state of connection can be maintained.

**In the Drawings**
Fig. 1(A) is a perspective view showing a structure of a connecting terminal in a first embodiment according to the invention, and
Fig. (B) is a side view showing the structure of the connecting terminal in the first embodiment.
Fig. 2 is a sectional view as seen in a direction of arrows II-II in Fig. 1(A).
Fig. 3 is a sectional view showing a state of the connecting terminal in use.
Fig. 4(A) is a perspective view showing a structure of a connecting terminal in a second embodiment according to the invention.
Fig. 4(B) is a side view of a connecting terminal in the second embodiment.
Fig. 4(C) is a view of a projected part as seen from the above in the second embodiment.
Fig. 4(D) is a sectional view as seen in a direction of arrows IV-IV in Fig. 4(C).
Fig. 5 (A) is view showing modified example of the projected part in the above described embodiments.
Fig. 5 (B) is view showing modified example of the projected part in the above described embodiments.
Fig. 5 (C) is view showing modified example of the projected part in the above described embodiments.
Fig. 6 is a perspective view showing a structure of a connecting terminal in a third embodiment according to the invention.
Fig. 7 is a perspective view showing a structure of a connecting terminal in a fourth embodiment according to the invention.
Fig. 8 (A) is a perspective view showing a structure of a conventional connecting terminal.
Fig. 8 (B) is a sectional view showing a state of the conventional connecting terminal in use.

Now, an embodiment according to the invention will be described in detail referring to the drawings.

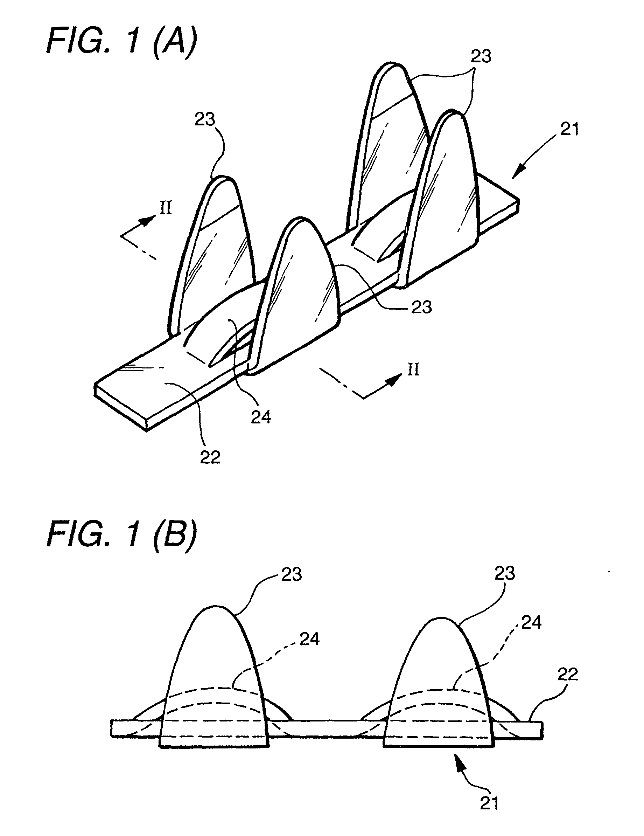

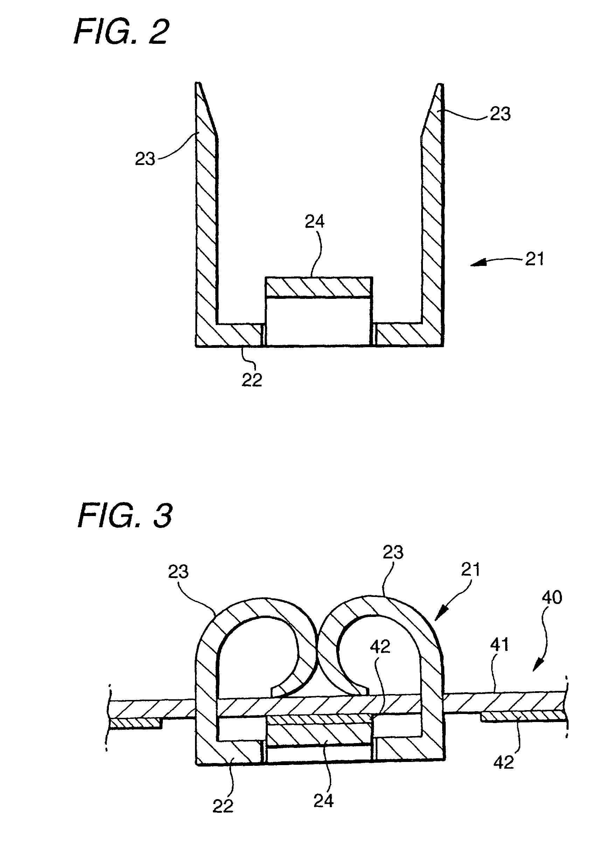

Fig. 1(A) is a perspective view showing a structure of a connecting terminal 21 in a first embodiment according to the invention, Fig. 1(B) is a side view, and Fig. 2 is a sectional view as seen in a direction of arrows II-II in Fig. 1(A).

This connecting terminal 21 includes a strip portion 22, two pairs of claw portions 23 projecting from both side edges of the strip portion 22 in parallel to a direction of a thickness of the strip portion 22, and projected parts 24 elastically formed on an upper face of the strip portion 22 in a direction of the thickness of the strip portion 22. The whole connecting terminal 21 is integrally formed by press molding from a sheet of metal plate. The claw portions 23 are symmetrically arranged on both sides of the strip portion 22. The projected parts 24 are provided between the pairs of the claw portions 23 respectively, and formed by partially cutting out the strip portion 22. Therefore, number of the components can be reduced as compared with a case wherein the projected parts 24 are formed of separate members to be assembled, and can be manufactured at a low cost. Further, due to the arcuately curved shape in a longitudinal direction of the strip portion 22, the projected parts 24 are elastically deformable in the direction of the thickness of the strip portion 22 with flexibility.

When the connecting terminal 21 constructed in this manner is put to use, after the connecting terminal 21 is positioned below a conductive part 42 of a flat circuit body 40 as shown in Fig. 3, the claw portions 23 are passed through an insulating part 41 of the flat circuit body 40 and then, the tip ends of the claw portions 23 are folded back toward the strip portion 22 while being curled, thereby to hold the conductive part 42 between the strip portion 22 and the claw portions 23. Thus, the connecting terminal 21 is electrically connected to the flat circuit body 40.

On this occasion, because the conductive part 42 is clamped between the elastic projected parts 24 and the claw portions 23 formed on the strip portion 22, forces from the claw portions 23 can be relieved by the elastic deformation of the projected parts 24 even in case where the conducted part 42 is pressed with the tip ends of the claw portions 23 with strong forces. Accordingly, the claw portions 23 will not be press-contacted to the conductive part 42 with the force above the prescribed value, and the problem of damaging the conductive part 42 will be solved. In this case, favorable elasticity can be obtained because the projected parts 24 are projected in an arcuate shape from the strip portion 22, and accordingly, excessive forces from the claw portions 23 can be effectively relieved.

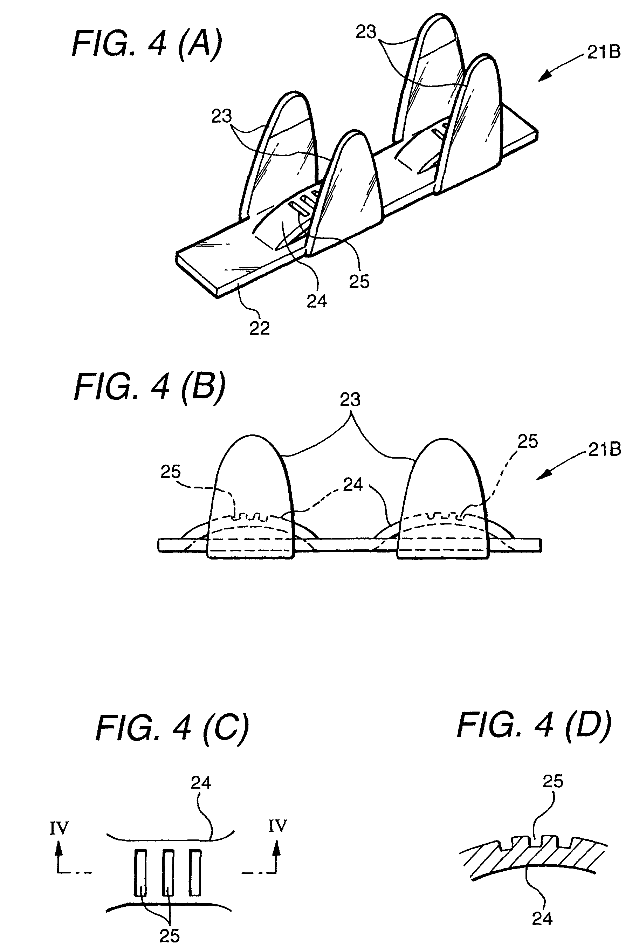

Fig. 4(A) is a perspective view showing a structure of a connecting terminal 21B in a second embodiment according to the invention, Fig. 4(B) is a side view, Fig. 4(C) is a view of the projected part 24 as seen from the above, and Fig. 4(D) is a sectional view as seen in a direction of arrows IV-IV of Fig. 4(C). In this connecting terminal 21B, each of the projected parts 24 is provided with unevenness portion 25 arranged in a longitudinal direction of the strip portion 22 on its contact face with respect to the conductive part 42 (refer to Fig. 3). Other components of the structure are the same as those of the connecting terminal 21 in the first embodiment as shown in Figs. 1 to 3.

In case of this connecting terminal 21B, since the unevenness portion 25 are formed on the contact face of the projected part 24, a contact area with respect to the conductive part 42 of the flat circuit body 41 (refer to Fig. 3) is enlarged, and favorable conductivity can be obtained as compared with the case where the unevenness portion 25 are not formed. Further, because a surface of the conductive part 42 is press-contacted to the unevenness portion 25, the flat circuit body 40 will not be displaced with respect to the connecting terminal 21 in a longitudinal direction and a favorable state of connection can be maintained.

It is to be noted that the connecting terminal of the flat circuit body according to the invention is not restricted to the above described embodiments, but appropriate modifications and improvements can be made.

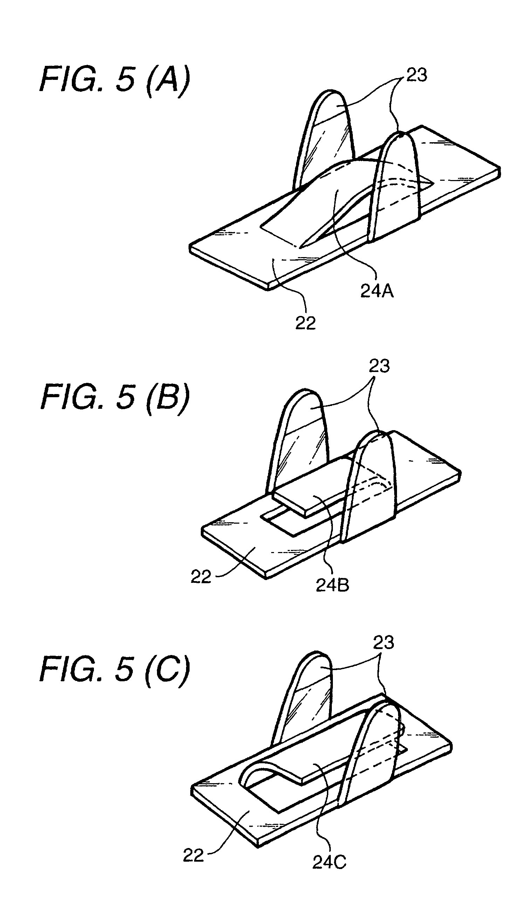

For example, in case where the projected part 24 is formed by cutting out and raising a portion of the strip portion 22 as described above, besides the projected part 24 of a type wherein both ends of a projected part 24A in the longitudinal direction of the strip portion 22 are connected to the strip portion 22 as shown in Fig. 5(A), a projected part of a cantilever type wherein it is connected to the strip portion 22 at only one end as shown in Fig. 5(B) can be employed. Alternatively, an end of a projected part 24C in a widthwise direction of the strip portion 22 may be connected to the strip portion 22 as shown in Fig. 5(C) instead of connecting an end of the projected part 24C in the longitudinal direction of the strip portion 22.

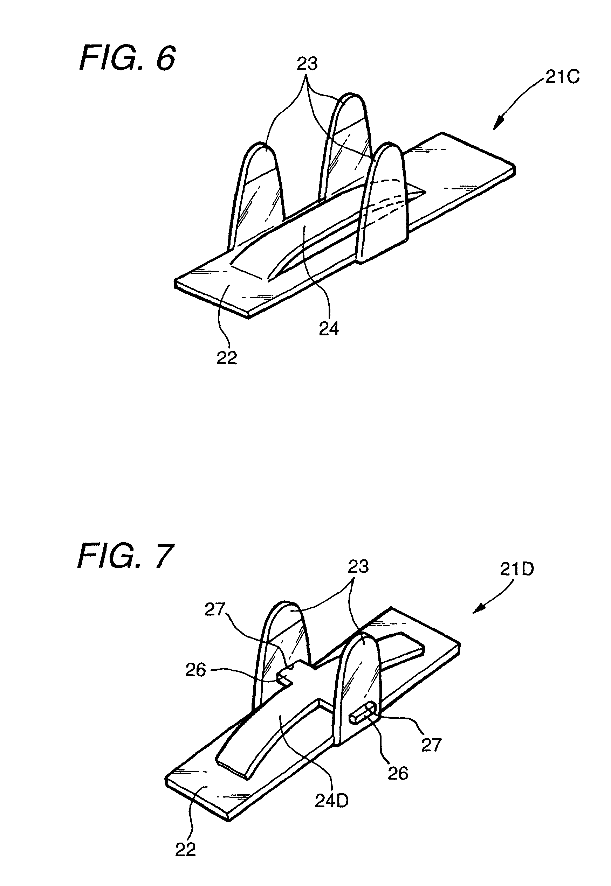

The claw portions 23 may be in any shape at their tip ends or in any number provided that the conductive part 40 can be clamped between the claw portions 23 and the strip portion 22. The left and right claw portions 23 may be arranged in a staggered relation in the longitudinal direction of the strip portion 22 as in a connecting terminal 21C in a third embodiment as shown in Fig. 6.

Further, a projected part 24D may be manufactured as a separate body from the strip portion 22 in a form of a leaf spring, and assembled between a pair of the claw portions 23 by means of projections 26 and openings 27 as in a connecting terminal 21D in a fourth embodiment as shown in Fig. 7.

The strip portion 22 and the claw portions 23 themselves may be also formed as separate bodies and then, assembled into an integral body by welding or with a conductive adhesive.

The projected part 24 may be composed of an elastic material such as rubber and attached to the strip portion 22, because the projected part 24 need not have conductivity necessarily.

Other features such as materials, dimensions, shapes and numbers of the strip portions, the claw portions and the projected parts illustrated in the above described embodiments are not restricted but may be optional, provided that the invention can be attained.

As explained above, according to the invention, the elastically projected parts are formed on the strip portion. Accordingly, in case where the tip ends of the claw portions have pressed the conductive part with a strong force when the claw portions are passed through the insulating part,of the flat circuit body and folded back, the projected parts will be elastically deformed to relieve the force of the claw portions, and prevent the claw portions from being press-contacted to the conductive part with a force above the prescribed value. Therefore, even though the claw portions are not formed with high precision so that the projected length may be within the prescribed value, there will be no fear of damaging the conductive part of the flat circuit body. Thus, the manufacturing cost can be decreased.

Moreover, according to the invention, the projected part is formed by partially cutting out the strip portion. Accordingly, the increase of the manufacturing cost can be restrained, as compared with the case wherein the projected part is formed of separate material and then, assembled.

Further, according to the invention, the projected part is projected from the strip portion in an arcuate shape, and the favorable elasticity can be obtained.

Still further, according to the invention, the projected part is provided with the unevenness portion on its contact face with respect to the conductive part. Accordingly, the area to be in contact with the conductive part can be enlarged as compared with the case where the unevenness portion are not provided, and the favorable conductivity can be obtained when the projected part is made of metal. Since the surface of the conductive part is press-contacted to the unevenness portion, a fear of positional displacement of the flat circuit body with respect to the connecting terminal will be substantially eliminated, whereby the favorable state of connection can be maintained.

## Claims

1. A connecting terminal (21) adapted to be electrically connected to a conductive part (42) of a flat circuit body (40), the connecting terminal comprising:
a strip portion (22);
at least one claw portion (23) projected from the strip portion in a direction of the thickness of the strip portion; **characterised by**
at least one projected part (24) being elastically projected from the strip portion (22) in said direction.

2. A connector terminal (21) according to claim 1, wherein the projected part (24) is formed by partially cutting out and raising a portion of the strip portion (22) corresponding to the projected part.

3. A connector terminal (21) according to claim 1, wherein the projected part (24) is projected from the strip portion (22) in an arcuate shape.

4. A connector terminal (21) according to claim 1, wherein the projected part (24) is provided with unevenness part on a contact face of the projected part with respect to the conductive part (42).

5. A connector terminal (21) according to claim 1, wherein the claw portion (23) is penetrated to a insulating part of the flat circuit body (40) in the direction and is folded back toward the strip portion (22) to hold the conductive part (42) between the claw portion and the projected part so that the connecting terminal is electrically connected to the conductive part.

6. A connector terminal (21) according to claim 1, wherein a pair of the claw portions (23) is positioned both sides of the projected part (24).

7. A connector terminal (21) according to claim 6, wherein the projected part (24) is separate from the strip portion (22) and assembled between the pair of the claw portions (23).

8. A connector terminal (21) according to claim 2, wherein the portion is partially cut in parallel with a surface of the claw portion (23).

9. A connector terminal (21) according to claim 2, wherein the portion is partially cut perpendicular to a surface of the claw portion (23).

10. A connector terminal (21) according to claim 1, wherein the projected part (24) has at least one end connected to the strip portion (22), and a contact face extending from the at least one end and distanced from the strip portion in the direction to define and opening between the contact portion and the strip portion in the direction.

## Patentansprüche

1. Verbindungsanschluss (21), der so eingerichtet ist, dass er elektrisch mit einem leitenden Teil (42) eines flachen Schaltungskörpers (40) verbunden wird, wobei der Verbindungsanschluss umfasst:
einen Streifenabschnitt (22);
wenigstens einen Klauenabschnitt (23), der von dem Streifenabschnitt in einer Richtung der Dicke des Streifenabschnitts vorsteht; **gekennzeichnet durch:**
wenigstens einen vorstehenden Teil (24), der in der Richtung elastisch von dem Streifenabschnitt (22) vorsteht.

2. Verbinderanschluss (21) nach Anspruch 1, wobei der vorstehende Teil (24) ausgebildet wird, indem ein Abschnitt des Streifenabschnitts (22), der dem vorstehenden Teil entspricht, teilweise ausgeschnitten und angehoben wird.

3. Verbinderanschluss (21) nach Anspruch 1, wobei der vorstehende Teil (24) in einer Bogenform von dem Streifenabschnitt (22) vorsteht.

4. Verbinderanschluss (21) nach Anspruch 1, wobei der vorstehende Teil (24) mit einem Unebenheitsteil an einer Kontaktfläche des vorstehenden Teils in Bezug auf den leitenden Teil (42) versehen ist.

5. Verbinderanschluss (21) nach Anspruch 1, wobei der Klauenabschnitt (23) in der Richtung in einen isolierenden Teil des flachen Schaltungskörpers (40) eingeführt wird und auf den Streifenabschnitt (22) zu zurück gebogen wird, um den leitenden Teil (42) zwischen dem Klauenabschnitt und dem vorstehenden Teil zu halten, so dass der Verbindungsanschluss elektrisch mit dem leitenden Teil verbunden ist.

6. Verbinderanschluss (21) nach Anspruch 1, wobei ein Paar der Klauenabschnitte (23) auf beiden Seiten des vorstehenden Teils (24) angeordnet ist.

7. Verbinderanschluss (21) nach Anspruch 6, wobei der vorstehende Teil (24) von dem Streifenabschnitt (22) getrennt ist und zwischen dem Paar der Klauenabschnitte (23) eingefügt ist.

8. Verbinderanschluss (21) nach Anspruch 2, wobei der Abschnitt parallel zu einer Oberfläche des Klauenabschnitts (23) teilweise geschnitten ist.

9. Verbinderanschluss (21) nach Anspruch 2, wobei der Abschnitt senkrecht zu einer Oberfläche des Klauenabschnitts (23) teilweise geschnitten ist.

10. Verbinderanschluss (21) nach Anspruch 1, wobei der vorstehende Teil (24) wenigstens ein Ende, das mit dem Streifenabschnitt (22) verbunden ist, sowie eine Kontaktfläche aufweist, die sich von dem wenigstens einen Ende aus erstreckt und in der Richtung von dem Streifenabschnitt beabstandet ist, um in der Richtung eine Öffnung zwischen dem Kontaktabschnitt und dem Streifenabschnitt auszubilden.

## Revendications

1. Borne de raccordement (21) adaptée pour être électriquement raccordée à une partie conductrice (42) d'un corps de circuit plat (40), la borne de raccordement comprenant :
une partie de bande (22)
au moins une partie de griffe (23) faisant saillie à partir de la partie de bande dans une direction de l'épaisseur de partie de bande ; **caractérisée par**
au moins une partie faisant saillie (24), faisant saillie élastiquement à partir de la partie de bande (22) dans ladite direction.

2. Borne de raccordement (21) selon la revendication 1, dans laquelle la partie faisant saillie (24) est formée en découpant partiellement et en soulevant une partie de la partie de bande (22) correspondant à la partie faisant saillie.

3. Borne de raccordement (21) selon la revendication 1, dans laquelle la partie faisant saillie (24) fait saillie à partir de partie de bande (22) dans une forme arquée.

4. Borne de raccordement (21) selon la revendication 1, dans laquelle la partie faisant saillie (24) est pourvue d'une partie irrégulière sur une face de contact de la partie faisant saillie par rapport à la partie conductrice (42).

5. Borne de raccordement (21) selon la revendication 1, dans laquelle la partie de griffe (23) pénètre dans une partie d'isolation du corps de circuit plat (40) dans la direction et est repliée vers la partie de bande (22) pour maintenir la partie conductrice (42) entre la partie de griffe et la partie faisant saillie pour que la borne de raccordement soit électriquement raccordée à la partie conductrice.

6. Borne de raccordement (21) selon la revendication 1, dans laquelle une paire de parties de griffe (23) est positionnée des deux côtés de la partie faisant saillie (24).

7. Borne de raccordement (21) selon la revendication 6, dans laquelle la partie faisant saillie (24) est séparée de la partie de bande (22) et est assemblée entre la paire de parties de griffe (23).

8. Borne de raccordement (21) selon la revendication 2, dans laquelle la partie est partiellement découpée parallèlement à une surface de la partie de griffe (23).

9. Borne de raccordement (21) selon la revendication 2, dans laquelle la partie est partiellement découpée perpendiculairement à une surface de la partie de griffe (23).

10. Borne de raccordement (21) selon la revendication 1, dans laquelle la partie faisant saillie (24) a au moins une extrémité raccordée à la partie de bande (22), et une face de contact s'étendant à partir d'au moins une extrémité et distante de la partie de bande dans la direction pour définir une ouverture entre la partie de contact et la partie de bande dans la direction.
